# EUROPEAN PATENT SPECIFICATION

(11) **EP 0 375 534 B1**
(45) Date of publication and mention of the grant of the patent: **12.06.1996**
(21) Application number: 89403531.0
(22) Date of filing: 18.12.1989
(51) Int. Cl.: G03F 1/08

(54) **Photomask and manufacturing method therefor**
Photomaske und Herstellungsverfahren
Photomasque et procédé de fabrication

(30) Priority: 20.12.1988 JP 325077/88
(43) Date of publication of application: 27.06.1990
(73) Proprietor: FUJITSU LIMITED, Kawasaki-shi, Kanagawa 211 (JP)
(72) Inventor: Ban, Yasutaka, Yokohama-shi Kanagawa 227 (JP); Tokitomo, Kazuo, Kawasaki-shi Kanagawa 213 (JP)
(74) Representative: Joly, Jean-Jacques

(56) References cited:
- US-A- 3 512 969
- US-A- 3 580 688
- US-A- 3 909 270
- PATENT ABSTRACTS OF JAPAN vol. 7, no. 67 (P-184)(1212) 19 March 1983,& JP-A-57 212447
- CHEMICAL ABSTRACTS, vol. 87, no. 10, 05 September 1977 Columbus, Ohio, USAGagarin A.P. et al.: "Recording an image in the far UV spectral region onnonactivated silcate glass" ref. no. 76338H

## Description

### BACKGROUND OF THE INVENTION

### 1. Field of the Invention

The present invention relates to a photomask for ultraviolet (UV) to deep ultraviolet light exposure, and particularly to a photomask in which the mask pattern is formed by color centers.

With improvements leading to higher and higher integration densities in semiconductor integrated circuits, submicron photolithography has now become indispensable. Accordingly, there is a corresponding need to use shorter wavelength light for the exposure operations. With these developments, the UV radiation known as the G-line or I-line classically obtained from a high pressure mercury lamp is now produced by an excimer laser. For example, dimer type excimer lasers consisting of a rare gas and a halogen gas - such as xenon chloride (XeCl), krypton fluoride (KrF) and argon fluoride (ArF) - emit laser radiation having wavelengths of 306 nm, 248 nm and 198 nm, respectively. Of these laser beams, the 306 nm wavelength produced by the XeCl excimer laser is not significantly different from the 365 nm wavelength obtained from the I-line of high pressure mercury lamps. Consequently, there is no real advantage to be gained from using such a laser source for the exposure of fine patterns, and only the light of 248 nm and 198 nm wavelengths (comprised in the so-called deep-UV spectrum) emitted by KrF excimer laser or ArF excimer laser is now thought to provide the kind of excellent results needed for the exposure to form a fine pattern.

### 2. Description of the Prior Art

A UV or deep-UV photomask, corresponding to a light source for exposure to UV or deep-UV is necessary for photolithography. The prior art photomasks used for this application are typically fabricated by the following method. A thin, light-absorbing film such as chromium (Cr) or chromium oxide (CrOₓ) is formed on a mask substrate that is transparent to the UV or deep UV-light. The surface is then coated with a resist film and patterned by electron beam lithography or UV light lithography. Using this resist pattern as the mask, the chromium, or chromium oxide, film is patterned and the desired photomask can thus be fabricated as described above.

Not only is such a photomask fabrication method complicated, but the accuracy of the photomask formed is governed by both the accuracy of resist pattern and etching accuracy of chromium, or chromium oxide, film. Consequently, the resulting photomask proves to be unsuitable for the production of sub-micron devices.

In the UV and deep-UV wavelength band, there is usually a significant amount of absorption of light, as well as ambient gas, by the optical system's components, such as the projection lens and the photomask substrate. Moreover, the irradiation at UV and deep-UV wavelengths generates color center type lattice defects in the optical materials, which has the effect of lowering their transmissivity. As a result, there arises the problem of the exposure intensity becoming unacceptably low. Accordingly, the selection of suitable materials for the photomask substrate is particularly important.

The processes involved in the generation of color centers and their properties have been investigated from various aspects and described in detail, e.g. in the books by J. H. Schulman and W. D. Compton entitled: "Color Centers in Solids", The MacMillan Co. (1962) and by W. B. Fowler: "The Physics of Color Centers", (edited by W. B. Fowler) Academic Press (1968).

A photomask obtained by electron beam irradiation of an ionic crystal to selectively create light shielding matter is disclosed in JP-A-57 212 447. The corresponding photomask is comprised of a NaCl sensitive film deposited on a glass substrate and overlaid with a conductive film for protection against electrical breakdown.

In the field of photographic processing, e.g. for microfiches, it is known from US-A-3 512 969 to use a recording medium having a surface sensitized by the formation of color centers through selective exposure to penetrating radiation. The image is thereafter stabilized by means of an electric field.

### SUMMARY OF THE INVENTION

It is an object of the present invention to simplify the fabrication of UV or deep-UV photomasks.

It is another object of the present invention to improve the patterning accuracy of UV or deep-UV photomasks.

These objects are achieved by a photomask of the present invention as defined in claim 1, to be used for photolithography utilizing light having a wavelength comprised in the ultraviolet to deep-ultraviolet wavelength region of the spectrum.

Preferably, the color center is generated in a halogenide of an alkali metal such as crystalline lithium fluoride (LiF) or halogenide of an alkaline-earth metal such as crystalline calcium fluoride (CaF₂) to form the UV to deep-UV light absorbing material. CaF₂ is particularly well suited as a substrate material because it is highly transmissive to UV to deep-UV light. The color center may be formed by selectively irradiating the predetermined region of such a CaF₂ substrate with the UV or X-rays. The color center will normally absorb light in the visible light to deep-UV light range, and a photomask for the UV to deep-UV band may accordingly be fabricated by tailoring the color centers to the determined pattern.

A pattern formed by color centers is essentially a pattern of light absorbing regions defined at the atomic level. For instance, such a pattern may be based on the displacement of lattice atoms or lattice ions in a CaF₂ crystal forming a substrate, or on the excited state of electrons generated by emission or trapping of electrons. Therefore, in the pattern consisting of color centers, the recessed and projected areas do not exist at the surface of substrate, unlike the pattern formed by the Cr thin film. Accordingly, a pattern consisting of color centers can be considered as a mask pattern having an extremely high resolving power.

The present invention also relates to a method of manufacturing the aforementioned photomask (claim 3) and to its use for tranferring a pattern (claim 10).

Moreover, the fabrication process for the inventive mask is simplified in comparison with conventional photomask fabrication methods which involve such processes as forming light absorbing material, e.g. thin film of Cr on the substrate, forming a resist thereon, patterning the resist, and selectively etching the light absorbing film.

Another advantage of the invention is that since the color center is annealable by heat treatment, it is easy to revise (partially omit or add) pattern-work after fabrication of the photomask and to recover, or re-cycle the mask. As a result, the practical use for the photomask can be increased, and a cost reduction can also be obtained.

### BRIEF DESCRIPTION OF THE DRAWINGS

Fig. 1(a) is a schematic sectional view indicating a layout of an original photomask for deep-UV processes having an original pattern and a photomask substrate for fabricating a pattern corresponding to the original pattern;
Fig. 1(b) is a schematic sectional view indicating a step for fabricating a pattern corresponding to the original pattern on the photomask substrate by irradiation of deep-UV from the rear face of the original photomask;
Fig. 1(c) is a schematic sectional view of a photomask fabricated by deep-UV irradiation;
Fig. 2 is a schematic diagram indicating resist exposure of a wafer using a photomask fabricated by the method of the present invention;
Fig. 3(a) is a schematic sectional view showing the formation of a positive type resist (OFPR-800) on an SiO₂ film formed on the surface of a silicon wafer;
Fig. 3(b) is a schematic sectional view showing the formation of a negative resist (PVSS) on the positive type resist (OFPR-800);
Fig. 3(c) is a schematic sectional view indicating a resist pattern formed by exposing the negative resist (PVSS) through the photomask obtained by the present invention and then developing the negative resist;
Fig. 3(d) is a schematic sectional view indicating a resist pattern formed by removing the positive type resist (OFPR-800) using reactive ion etching by oxygen, with the resist pattern shown in Fig. 3(c) used as the mask;
Fig. 4(a) is a schematic diagram of an original photomask for an X-ray process having an original pattern and a photomask substrate layout for fabricating a pattern corresponding to the original pattern;
Fig. 4(b) is a schematic diagram indicating a step for fabricating a pattern corresponding to the original pattern on a photomask substrate by X-ray irradiation from the rear face of the original photomask;
Fig. 4(c) is a schematic diagram of a photomask fabricated by X-ray irradiation; and
Fig. 5 is a partial plan view of a photomask pattern having defects to be revised.

### DESCRIPTION OF THE PREFERRED EMBODIMENTS

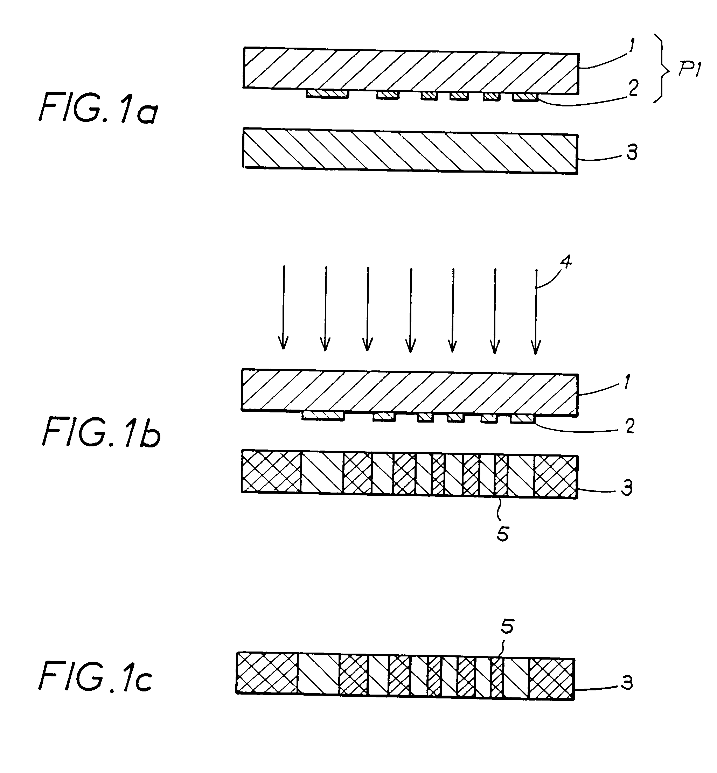

Three embodiments of the present invention will be explained hereunder with reference to the drawings from Figs. 1 to 5.

### First embodiment

Figs. 1(a) to 1(c) are schematic sectional diagrams of the essential parts of the fabrication process of photomask by the present invention. In Fig. 1(a), an original photomask P1 forming an original pattern 2 is fabricated by electron beam lithography or UV-lithography by initially producing a light absorbing film, such as Cr film, on a substrate 1 such as a quartz (SiO₂) plate. A CaF₂ crystal substrate 3 that exhibits high transmissivity to UV to deep-UV radiation is located in a confronting position with respect to the photomask P1. The rear surface of the original photomask P1 is irradiated with the KrF excimer laser having the wavelength of 248 nm (symbolized by arrows 4 in Fig. 1(b)). Here, the energy of the laser beam 4 irradiating the substrate 3 through the photomask P1 should be at least 10 J/cm². Since color centers are generated at parts of the substrate 3 irradiated by the laser beam 4, there will be produced on the substrate 3 a mask pattern 5 consisting of aggregations of color centers located at parts corresponding to the original pattern 2 shown in Fig.1(c). The original pattern 2 and mask pattern 5 are in a positive-negative relationship.

The contrast of the thus obtained photomask - defined as the ratio of the light flux transmitted by the photomask without shielding from the mask pattern to the incident light flux which is shielded and attenuated by the mask pattern - is in excess 10.

In the first embodiment, crystalline CaF₂ has been used as the substrate 3. But it is also possible to use quartz for the fabrication of a UV photomask, or to use a halogenide of alkali metal such as of crystalline lithium fluoride (LiF) or a halogenide of an alkaline-earth metal such as crystalline barium fluoride (BaF₂) for fabrication of photomask for deep-UV.

There is a gradual decline in light transmissivity at the level of the substrate 1 of the original photomask P1 because color centers are also generated on the substrate 1 of original photomask P1 when forming a mask pattern 5 on the substrate 3. However, since the substrate 1 of original photomask P1 is uniformly irradiated with the deep-UV light, it will take longer for the contrast of the mask pattern 5 to fall to a given value, even when color centers are generated.

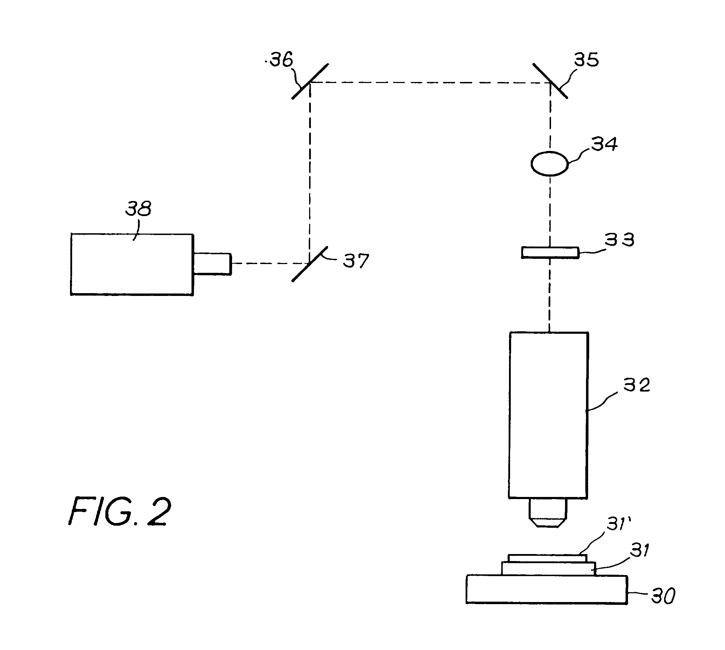

Fig. 2 is a schematic diagram indicating the apparatus used to obtain the photomask shown in Fig. 1(c). The laser beam (shown in dotted lines) has a wavelength of 248 nm and is emitted from a KrF excimer laser 38. The beam is reflected by the mirrors 37, 36, 35 and irradiates the photomask 33 of the present invention through a lens 34. The light having passed the photomask 33 partially exposes a wafer 31 through a projection lens system 32 for patterning of resist. The photomask 33 and the wafer 31, which is placed on a stage 30 are aligned by mechanically translating and rotating the stage 30 until the pattern provided on the photomask 33 and the wafer 31 are aligned. Once the alignment has been achieved, the pattern on the photomask 33 is transcribed onto the resist film 31' overlying wafer 31. Although an KrF excimer laser 38 is described in the embodiment, an ArF excimer laser can also be used instead of the KrF excimer laser 38. It should be noted that Fig 2 does not show the control system for reasons of clarity.

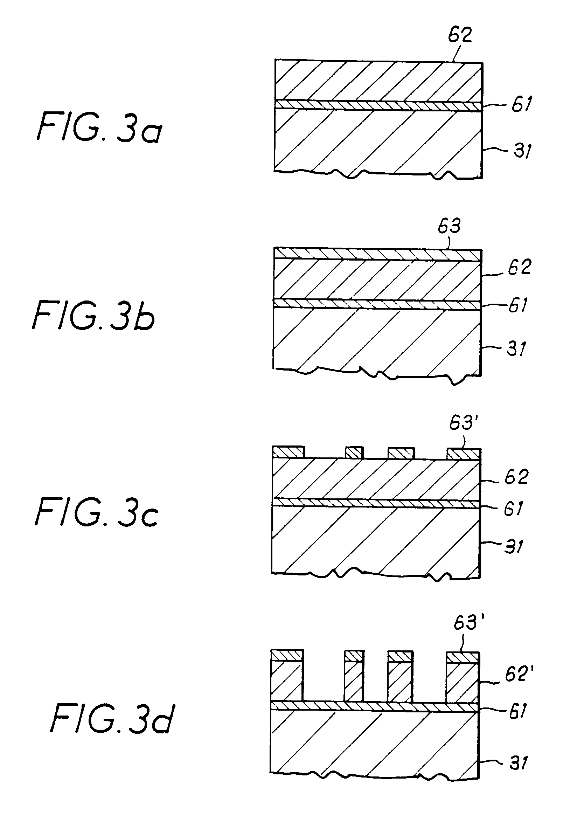

The resist patterning is carried out sequentially through the steps shown in Figs. 3(a) to 3(d). Figs. 3(a) and 3(b) show the sectional views of the various steps of the process for resist patterning. A suitable resist can for example be a double-layer type wherein the first layer is a Novolak system positive type photoresist OFPR-800 (a product of Tokyo Applied Chemical Industry Co.) and the second layer is a negative type photoresist PVSS (polyvinyl silsesquioxane). A positive type resist OFPR-800 shown in Fig. 3(a) is coated to the thickness of 1 to 1.5 microns as a first layer 62 on a silicon dioxide (SiO₂) film 61 formed on the surface of a silicon wafer 31. As shown in Fig. 3(b), a negative resist PVSS is coated in to a thickness of 0.2 microns as the second layer 63.

The thus prepared silicon wafer 31 is loaded to the stage 30 (shown in Fig. 2) and exposed through the photomask 33. In this case, the irradiation energy by KrF excimer laser 38 is 300 to 400mJ/cm². After the exposure, when the second layer 63 is developed, a resist pattern 63' as shown in Fig. 3(c) is obtained. Thereafter, when the first layer 62 is etched using the reactive ion etching by oxygen with the resist pattern 63' used as the mask, the resist pattern 62' as shown in Fig. 3(d) can be obtained, completing the resist patterning.

### Second embodiment

In the first embodiment, the deep-UV is used as the light source for exposure; it may however, be replaced with soft X-rays, as will now be explained.

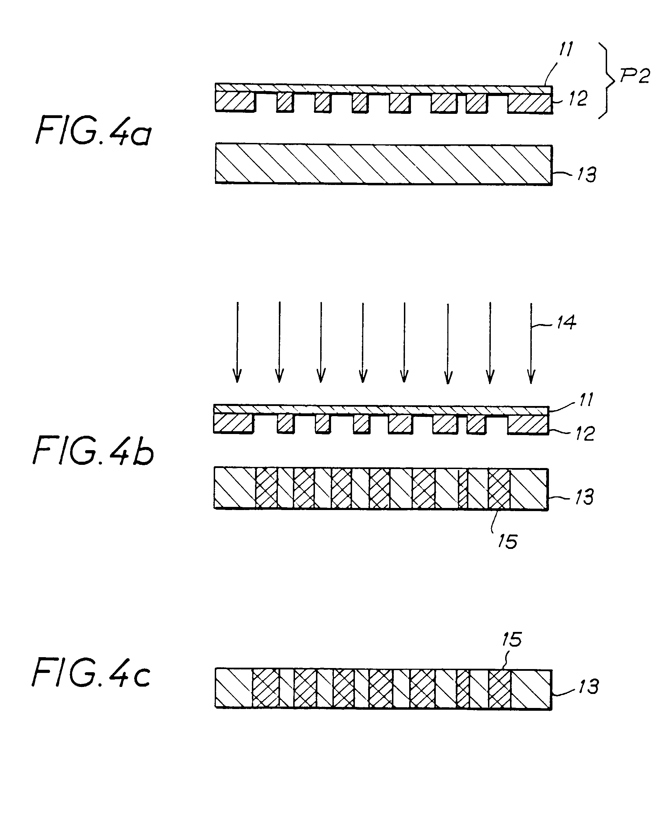

Figs. 4(a) to 4(c) are schematic sectional views illustrating the various steps in the fabrication process of photomask, using soft X-rays. In Fig. 4(a), a substrate 11 of the original X-ray mask P2 is made of an X-ray transmissive material such as silicon (Si), silicon dioxide (SiO₂), silicon nitride (Si₃N₄) or silicon carbide (SiC). The periphery of the substrate is fixed by a supporting frame. An original pattern 12 made of X-ray absorbing material such as gold (Au) or tantalum (Ta) is formed on the substrate 11. As in the first embodiment, the CaF₂ substrate 13 is located opposite the substrate 11 of original X-ray mask P2. The distance between the original pattern 12 and CaF₂ substrate 13 is set to 10 to 40 microns, and the original pattern 12 is therefore not in contact with the CaF₂ substrate 13.

As shown in Fig. 4(b), the rear face of the substrate 11 of original X-ray mask P2 is irradiated with the soft X-rays. The substrate 13 is selectively irradiated with the soft X-rays through the original pattern 12. The result, shown in Fig. 4(c),is a mask pattern 15 consisting of color centers which is generated according to the original pattern 12 formed on the substrate 11. Although the second embodiment uses a CaF₂ crystal for the substrate 13, it is also possible to use quartz for the fabrication of a UV photomask, and a halogenide of alkali metal such as crystalline lithium fluoride (LiF) or a halogenide of an alkaline-earth metal, such as crystalline calcium fluoride (CaF₂) and crystalline barium fluoride (BaF₂) for the fabrication of deep-UV photomasks.

The thickness of the Au or Ta film forming the original pattern 12 can be made so that a ratio: T(sub)/T(sub)T(m), where T(sub) and T(m) are the X-ray transmissivity of the substrate and the original pattern mask, respectively, i.e. an inverse number of transmissivity of original pattern 12, becomes greater than 10.

The soft X-rays 14 may be obtained by synchrotron radiation in the wavelength of 0.5 to 1.0 nm.

### Third embodiment

An embodiment of revision and recovery of photomask by the present invention will now be explained.

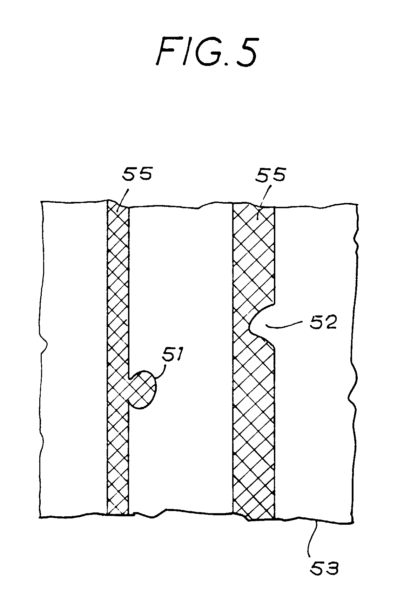

Fig. 5 is a partial plan view of a mask pattern in the photomask.

The mask pattern 55 is formed by color centers, and includes a projected defective part 51 and a recessed part 52. The size of these defective and recessed parts can be from several microns to several tens of microns. The projected defective part 51 is irradiated with a focused CO₂ laser beam or YAG laser beam so as to heat the portion of the substrate 53 to 200°C to 500°C.
As a result, the color center forming the projected defective part 51 disappears, thereby eliminating the projecting defective part 51.

When the recessed part 52 shown in Fig. 5 is selectively irradiated with the converted KrF excimer laser beam of 248 nm wavelength, or is irradiated through the photomask providing an aperture corresponding to the recessed part 52, a color center is generated at the recessed part 52, and thereby a complementary portion of the mask pattern is added to the recessed part 52.

The mask pattern formed by color centers of the present invention is capable of not only revising a pattern, but also of rewriting the desired pattern at the predetermined position of substrate 3 by a similar method.

Moreover, the substrate 3 or 13 may be re-used, by causing the entire mask pattern 5 or 15 formed on the substrate 3 or 13 to disappear. This can be achieved by eliminating color centers through a heat treatment throughout the substrate 3, 13, as shown in Figs. 1(c) and 4(c) at the temperature of 300°C to 500°C, under the inert gas environment.

Here, it is apparent that the term "photomask" used in the embodiments of the present invention can also be applied to a reticule to be used for a reduced projection exposure method.

## Claims

1. A photomask to be used for photolithography utilizing light having a wavelength comprised in the ultraviolet to deep-ultraviolet wavelength region of the spectrum, comprising : a first substrate (3; 13) made of a material which transmits the light ranging from ultraviolet to deep-ultraviolet wavelength region and in a predetermined region of which substrate is formed a mask pattern (5; 15) to be transcribed, said mask pattern being composed of color centers which absorb the light ranging from the visible to deep-ultraviolet wavelength region;
characterized in that said first substrate (3; 13) is made uniquely of material in which color centers can be formed by irradiation with light in the ultraviolet to deep-ultraviolet wavelength region of the spectrum, or soft X-rays.

2. A photomask according to claim 1, characterized in that said first substrate (13) is selected from the group comprising quartz, halogenides of alkali metals, and halogenides of alkaline earth metals.

3. A method for fabricating a photomask to be used for photolithography, characterized in that said method comprises the steps of :
- providing a first substrate (3; 13) transmitting light ranging from ultraviolet light to deep-ultraviolet light and made uniquely of material in which color centers can be formed by irradiation with light in the ultraviolet to deep-ultraviolet wavelength region of the spectrum, or soft X-rays;
- providing an original photomask (P1; P2) having original pattern (2; 12) which is formed on an original substrate (1; 11) transmitting light ranging from ultraviolet light to deep-ultraviolet light or soft X-rays, and said pattern absorbing light which corresponds to the light transmitting through said original substrate;
- arranging said original photomask so that it confronts said first substrate (3; 13); and
- forming a pattern (5; 15) comprised of color centers corresponding to said original pattern (2; 12) on said first substrate (3; 13) by irradiating said first substrate with the light transmitting through said original photomask (P1; P2).

4. A method for fabricating a photomask according to claim 3, characterized in that said first substrate (1; 11) forming said pattern formed by color centers is selected from the group of materials comprising quartz, halogenides of alkali metals and halogenides of alkaline earth metals.

5. A method for fabricating a photomask according to claim 3, characterized in that said pattern (5) is formed by color centers generated through irradiation of a calcium fluoride crystal substrate (1) a krypton fluoride excimer laser (38) producing radiation at 248 nm wavelength with an energy in excess of 10 J/cm².

6. A method for fabricating a photomask according to claim 3, characterized in that said pattern (15) is formed by color centers generated through irradiation of a calcium fluoride crystal substrate (13) with X-rays of 0.5 to 1.0 nm wavelengths.

7. A method for fabricating a photomask according to claim 3, characterized in that said method further comprises a step of eliminating color centers by selectively heating said color centers formed, corresponding to the original pattern, on the region of said first substrate (3; 13) which transmits the light ranging from ultraviolet light to deep ultraviolet light.

8. A method for fabricating a photomask according to claim 3, characterized in that said method further comprises a step of eliminating a pattern formed by color centers by heating the entirety of said first substrate (3; 13) forming said pattern.

9. A method for fabricating a photomask according to claim 7, characterized in that said color centers is eliminated by heating the part forming said color centers to a temperature in the range of 200°C to 500°C through irradiation of said color centers formed in calcium fluoride with a focused YAG (yttrium-aluminum-garnet) laser (38).

10. Use of the photomask according to claim 1 or 2 for transcribing a mask pattern (5. 15) formed on said photomask ( 3; 13) onto a photosensitive medium provided on a second substrate by exposing the photomask, comprising the steps of:
- positioning said photomask, comprising the first substrate (3; 13) made of a material which transmits the light ranging from an ultraviolet to a deep-ultraviolet wavelength region and the mask pattern (5; 15) to be transcribed composed of color centers which absorb light ranging from the visible to deep-ultraviolet wavelength in predetermined regions of said first substrate (1; 11), to said second substrate to be irradiated; and
- transcribing said mask pattern onto said photosensitive medium by irradiation with light ranging from ultraviolet light to deep-ultraviolet light on said photosensitive medium through said photomask.

11. Use of the photomask according to claim 1 or 2 for transcribing a mask pattern according to claim 10 characterized in that said irradiating light is produced by a krypton fluoride excimer laser emitting at a wavelength of 248 nm or an argon fluoride excimer laser emitting at a wavelength of 198 nm.

## Patentansprüche

1. Eine Photomaske zum Gebrauch bei der Photolithographie, die Licht einer Wellenlänge benutzt, die im ultravioletten bis tief-ultravioletten Wellenlängenbereich des Spektrums enthalten ist, bestehend aus: einem ersten Substrat (3; 13), das aus einem Stoff besteht, der das Licht des ultravioletten bis tief-ultravioletten Wellenlängenbereichs durchläßt und in einem vorher festgelegten Bereich des Substrats wird ein Maskenmuster (5; 15) gebildet, daß übertragen werden soll und genanntes Maskenmuster besteht aus Farbzentren, die das Licht vom sichtbaren bis tief-ultravioletten Wellenlängenbereich absorbieren;
dadurch gekennzeichnet, daß das erste Substrat (3; 13) einzigartigerweise aus Stoff hergestellt ist, in welchem Farbzentren durch Bestrahlung mit Licht im ultravioletten bis tief-ultravioletten Wellenlängenbereich des Spektrums oder mit weichen Röntgenstrahlen gebildet werden können.

2. Eine Photomaske nach Anspruch 1, gekennzeichnet dadurch, daß das genannte erste Substrat (13) aus der Gruppe, die aus Quarz, Halogeniden von Alkalimetallen und Halogeniden von Erdalkalimetallen besteht, gewählt ist.

3. Ein Verfahren zur Herstellung einer Photomaske für den Gebrauch in der Photolithographie, dadurch gekennzeichnet, daß das genannte Verfahren die folgende Schritte enthält:
- Vorsehen eines ersten Substrats (3; 13), das Licht im Bereich vom ultravioletten Licht bis zum tief-ultravioletten Licht durchläßt und das einzigartigerweise aus Stoff besteht, in dem durch Bestrahlung mit Licht im ultravioletten bis tief-ultravioletten Wellenlängenbereich des Spektrums oder mit weichen Röntgenstrahlen Farbzentren gebildet werden können;
- Vorsehen einer Original-Photomaske (P1; P2) mit einem Original-Muster (2; 12), das auf einem Originalsubstrat (1; 11) gebildet wird, welches Licht im Bereich vom ultravioletten bis tief-ultravioletten Licht oder weiche Röntgenstrahlen durchläßt, und welches Muster Licht absorbiert, welches mit dem Licht übereinstimmt, das durch das genannte Original-Substrat gesendet wird;
- Anordnen der genannten Original-Photomaske so, daß sie dem genannten ersten Substrat (3; 13) gegenüberliegt; und
- Bilden eines Musters (5; 15), das aus Farbzentren besteht, die mit dem genannten Original-Muster (P1; P2) auf dem genannten ersten Substrat (3; 13) übereinstimmen, durch Bestrahlen des genannten ersten Substrats mit dem Licht, das durch die genannte Original-Photomaske (P1; P2) gesendet wird.

4. Ein Verfahren zur Herstellung einer Photomaske gemäß Anspruch 3, dadurch gekennzeichnet, daß das erste Substrat (1; 11) welches das genannte Muster bildet, aus der Gruppe von Stoffen gewählt wird, die aus Quarz, Halogeniden von Alkalimetallen und Halogeniden von Erdalkalimetallen besteht.

5. Ein Verfahren zur Herstellung einer Photomaske gemäß Anspruch 3, dadurch gekennzeichnet, daß das genannte Muster (5) von Farbzentren gebildet wird, die durch Bestrahlung eines Substrats aus einem Kalziumfluoridkristall (1) mit einem Kryptonluoridlaser (38) einer Strahlung von 248 nm Wellenlänge mit einer Energie von mehr als 10 J/cm² erzeugt werden.

6. Ein Verfahren zur Herstellung einer Photomaske gemäß Anspruch 3, dadurch gekennzeichnet, daß das genannte Muster (15) von Farbzentren gebildet wird, die durch Bestrahlung eines Substrats aus einem Kalziumfluoridkristall (13) mit Röntgenstrahlen von 0.5 bis 1.0 nm Wellenlänge erzeugt werden.

7. Ein Verfahren zur Herstellung einer Photomaske gemäß Anspruch 3, dadurch gekennzeichnet, daß das genannte Verfahren einen weiteren Schritt enthält, mit dem genannte Farbzentren durch selektiv gewähltes Erhitzen der genannten Farbzentren eliminiert werden, die, entsprechend dem Original-Muster, im Bereich des genannten ersten Substrats (3; 13), welches das Licht im Bereich vom ultra-violetten bis zum tief-ultravioletten Licht durchläßt, ausgebildet sind.

8. Ein Verfahren zur Herstellung einer Photomaske gemäß Anspruch 3, dadurch gekennzeichnet, daß das genannte Verfahren einen weiteren Schritt des Eliminierens eines von durch Farbzentren gebildeten Musters durch Erhitzen der Gesamtheit des genannten ersten Substrats (3; 13), welches das Muster bildet, enthält.

9. Ein Verfahren zur Herstellung einer Photmaske gemäß Anspruch 7, dadurch gekennzeichnet, daß die genannten Farbzentren dadurch entfernt werden, daß der Teil, der die Farbzentren bildet, auf eine Temperatur im Bereich von 200°C bis 500°C durch Bestrahlung der genannten, in Kalziumflorid gebildeten Farbzentren mit einem fokussierten YAG- (Yttrium-Aluminium-Granat) -Laser (38) erhitzt wird.

10. Verwendung der Photomaske gemäß Anspruch 1 oder 2, um ein Maskenmuster (5; 15), daß auf der genannten Photomaske (3; 13) gebildet ist, auf ein lichtempfindliches Medium, welches auf einem zweiten Substrat vorgesehen ist, durch Bestrahlung der Photomaske zu übertragen, das die Schritte enthält:
- Positionieren der Photomaske, die das erste Substrat (3; 13), bestehend aus einem Stoff, der das Licht im Bereich der ultravioletten bis tief-ultravioletten Wellenlängen durchläßt und das zu übertragende Maskenmuster (5; 15), das aus Farbzentren besteht, die Licht im Bereich von sichtbarer bis tief-ultravioletter Wellenlänge in vorbestimmten Bereichen des genannten ersten Substrats (1; 11) absorbiert, aufweist, gegenüber dem zu bestrahlenden zweiten Substrat; und
- Übertragung des genannten Maskenmusters auf genanntes lichtempfindliches Medium durch Einstrahlen von Licht im Bereich von ultraviolettem Licht bis tief-ultraviolettem Licht auf genanntes lichtempfindliches Medium durch genannte Photomaske.

11. Verwendung der Photomaske gemäß Anspruch 1 oder 2 zur Übertragung eines Maskenmusters gemäß Anspruch 10, dadurch gekennzeichnet, daß das bestrahlende Licht von einem Kryptonfluorid-Excimerlaser, der bei einer Wellenlänge von 248 nm ausstrahlt, oder einem Argonfluorid-Excimerlaser, der bei einer Wellenlänge von 198 nm ausstrahlt, erzeugt wird.

## Revendications

1. Masque de photogravure destiné à être utilisé pour la photolithographie faisant appel à une lumière dont la longueur d'onde est comprise dans la région de longueurs d'onde du spectre allant de l'ultraviolet à l'ultraviolet lointain, qui comprend : un premier substrat (3 ; 13) fait d'un matériau qui transmet la lumière comprise dans la région de longueurs d'onde qui va de l'ultraviolet à l'ultraviolet lointain, et dans une région prédéterminée duquel substrat est formé un motif de masquage (5 ; 15) destiné à être transcrit, ledit motif de masquage étant constitué de centres colorés qui absorbent la lumière appartenant à la région de longueurs d'onde qui va du visible à l'ultraviolet lointain ;
caractérisé en ce que ledit premier substrat (3 ; 13) est fait uniquement d'un matériau dans lequel des centres colorés peuvent être formés par irradiation à l'aide d'une lumière appartenant à la région de longueurs d'onde du spectre qui va de l'ultraviolet à l'ultraviolet lointain, ou à l'aide de rayons X mous.

2. Masque de photogravure selon la revendication 1, caractérisé en ce que ledit premier substrat (13) est choisi dans un groupe comprenant le quartz, des halogénures de métaux alcalins et des halogénures de métaux alcalino-terreux.

3. Procédé de fabrication d'un masque de photogravure destiné à être utilisé en photolithographie, caractérisé en ce qu'il comprend les opérations suivantes :
- produire un premier substrat (3 ; 13) transmettant la lumière qui va de l'ultraviolet à l'ultraviolet lointain et fait uniquement d'un matériau dans lequel des centres colorés peuvent être formés par irradiation à l'aide d'une lumière appartenant à la région de longueurs d'onde du spectre qui va de l'ultraviolet à l'ultraviolet lointain, ou à l'aide de rayons X mous ;
- produire un masque de photogravure original (P1 ; P2) comportant un motif original (2 ; 12) formé sur un substrat original (1 ; 11) qui transmet la lumière allant de l'ultraviolet à l'ultraviolet lointain ou des rayons X mous, ledit motif absorbant la lumière qui correspond à la lumière transmise à travers ledit substrat original,
- disperser ledit masque de photogravure original de façon qu'il soit en regard dudit premier substrat (3 ; 13) ; et
- former un motif (5 ; 15) constitué par des centres colorés correspondant audit motif original (2 ; 12) présent sur ledit premier substrat (3 ; 13) en irradiant ledit premier substrat à l'aide de la lumière transmise à travers ledit masque de photogravure original (P1 ; P2).

4. Procédé de fabrication d'un masque de photogravure selon la revendication 3, caractérisé en ce qu'on choisit ledit premier substrat (1 ; 11) formant ledit motif constitué par des centres colorés dans un groupe de matériaux comprenant du quartz, des halogénures de métaux alcalins et des halogénures de métaux alcalino-terreux.

5. Procédé de fabrication d'un masque de photogravure selon la revendication 3, caractérisé en ce que ledit motif (5) est formé par des centres colorés qui sont produits par irradiation d'un substrat (1) en cristal de fluorure de calcium par un laser excimère du type à fluorure de krypton (38) qui produit un rayonnement de longueur d'onde 248 nm ayant une énergie qui dépasse 10 J/cm².

6. Procédé de fabrication d'un masque de photogravure selon la revendication 3, caractérisé en ce que ledit motif (15) est formé par des centres colorés créés par irradiation d'un substrat en cristal de fluorure de calcium (13) à l'aide de rayons X ayant des longueurs d'onde de 0,5 à 1,0 nm.

7. Procédé de fabrication d'un masque de photogravure selon la revendication 3, caractérisé en ce qu'il comprend en outre l'opération consistant à éliminer des centres colorés par chauffage sélectif desdits centres colorés formés, en correspondance avec le motif original, sur la région dudit premier substrat (3 ; 13) qui transmet la lumière allant de l'ultraviolet à l'ultraviolet lointain.

8. Procédé de fabrication d'un masque de photogravure selon la revendication 3, caractérisé en ce qu'il comprend en outre l'opération consistant à éliminer un motif formé par des centres colorés par chauffage de la totalité dudit premier substrat (3 ; 13) formant ledit motif.

9. Procédé de fabrication d'un masque de photogravure selon la revendication 7, caractérisé en ce qu'on élimine lesdits centres colorés en chauffant la partie formant lesdits centres colorés à une température comprise dans l'intervalle de 200 à 500°C par irradiation desdits centres colorés formés dans du fluorure de calcium à l'aide d'un laser du type YAG (grenat-yttrium-aluminium) focalisé (38).

10. Utilisation du masque de photogravure de la revendication 1 ou 2 pour transcrire un motif de masquage (5 ; 15), formé sur ledit masque de photogravure (3 ; 13), sur un support photosensible placé sur un deuxième substrat par exposition du masque de photogravure, comprenant les opérations suivantes :
- placer ledit masque de photogravure, qui comprend le premier substrat (3 ; 13) fait d'un matériau qui transmet la lumière comprise dans la région de longueurs d'onde allant de l'ultraviolet à l'ultraviolet lointain et le motif de masquage (5 ; 15) à transcrire qui est constitué de centres colorés qui absorbent la lumière dans l'intervalle de longueurs d'onde allant du visible à l'ultraviolet lointain dans des régions prédéterminées dudit premier substrat (1 ; 11), sur ledit deuxième substrat devant être irradié ; et
- transcrire ledit motif de masquage sur ledit support photosensible en irradiant ledit support photosensible, à travers ledit masque de photogravure, à l'aide d'une lumière appartenant à l'intervalle qui va de l'ultraviolet à l'ultraviolet lointain.

11. Utilisation du masque de photogravure de la revendication 1 ou 2 pour transcrire un motif de masquage, selon la revendication 10, caractérisée en ce que ladite lumière d'irradiation est produite par un laser excimère du type à fluorure de krypton qui émet à une longueur d'onde de 248 nm ou un laser excimère du type à fluorure d'argon qui émet à une longueur d'onde de 198 nm.
